(19) Europäisches Patentamt

European Patent Office

Office européen des brevets

(11) **EP 1 411 601 B1**

(12) **EUROPEAN PATENT SPECIFICATION**

(45) Date of publication and mention
of the grant of the patent:
**13.09.2006 Bulletin 2006/37**

(51) Int Cl.:
*H01S 5/022* (2006.01)    *H01S 5/12* (2006.01)
*G02B 6/42* (2006.01)    *H01S 5/00* (2006.01)
*G02B 27/10* (2006.01)

(21) Application number: **02736213.6**

(22) Date of filing: **02.07.2002**

(86) International application number:
**PCT/JP2002/006680**

(87) International publication number:
**WO 2003/005508 (16.01.2003 Gazette 2003/03)**

(54) **SEMICONDUCTOR LASER MODULE, OPTICAL AMPLIFIER, AND METHOD FOR MANUFACTURING SEMICONDUCTOR LASER MODULE**

HALBLEITERLASERMODUL, OPTISCHER VERSTÄRKER UND VERAHREN ZUM HERSTELLEN DES HALBLEITERLASERMODULS.

MODULE LASER A SEMI-CONDUCTEUR, AMPLIFICATEUR OPTIQUE ET PROCEDE DE FABRICATION D'UN MODULE LASER A SEMI-CONDUCTEUR

(84) Designated Contracting States:
**DE FR GB IT**

(30) Priority: **02.07.2001 JP 2001201513**
**17.07.2001 JP 2001217265**
**23.10.2001 JP 2001325705**
**08.02.2002 JP 2002033252**
**17.04.2002 JP 2002114510**

(43) Date of publication of application:
**21.04.2004 Bulletin 2004/17**

(73) Proprietor: **FURUKAWA ELECTRIC CO., LTD.**
**Tokyo 100-8322 (JP)**

(72) Inventors:
• **KIMURA, Toshio,**
**Furukawa Electric Co., Ltd**
**Tokyo 100-8322 (JP)**
• **NAKAE, Masashi,**
**Furukawa Electric Co., Ltd**
**Tokyo 100-8322 (JP)**
• **TSUKIJI, Naoki,**
**Furukawa Electric Co., Ltd**
**Tokyo 100-8322 (JP)**
• **YOSHIDA, Junji,**
**Furukawa Electric Co., Ltd**
**Tokyo 100-8322 (JP)**
• **OHKI, Yutaka,**
**Furukawa Electric Co., Ltd**
**Tokyo 100-8322 (JP)**
• **AIKIYO, Takeshi,**
**Furukawa Electric Co., Ltd**
**Tokyo 100-8322 (JP)**

(74) Representative: **Zimmermann, Gerd Heinrich et al**
**Zimmermann & Partner,**
**P.O. Box 33 09 20**
**80069 München (DE)**

(56) References cited:
EP-A- 0 312 652          EP-A- 1 215 782
EP-A1- 0 312 652        EP-A1- 1 085 622
JP-A- 1 291 480          JP-A- 4 369 888
JP-A- 5 053 082          JP-A- 5 121 838
JP-A- 7 099 477          JP-A- 9 162 490
US-A- 5 291 571          US-A- 5 692 082

• **PATENT ABSTRACTS OF JAPAN vol. 2000, no. 04, 31 August 2000 (2000-08-31) & JP 2000 031575 A (OKI ELECTRIC IND CO LTD), 28 January 2000 (2000-01-28)**
• **YOSHIHIRO EMORI ET AL.: 'Kothutsuryoku reiki kogen (HPU) no kaihatsu to kotaiiki raman zofukuki eno oyo' FURUKAWA DENKO GIHO no. 105, January 2000, pages 42 - 45, XP002955636**

Remarks:
The file contains technical information submitted after the application was filed and not included in this specification

EP 1 411 601 B1

**Description**

The present invention relates to a semiconductor laser module, an optical fiber amplifier and a method of manufacturing the semiconductor laser module. More particularly, the present invention relates to a semiconductor laser module and an optical fiber amplifier in which two laser beams are polarization-synthesized and then coupled to an optical fiber, and to a method of manufacturing the semiconductor laser module.

With progress in the optical communications based on a dense wavelength division multiplexing transmission system over the recent years, a higher output is increasingly demanded to a pumping light source used for the optical amplifier.

Further, a greater expectation is recently given to a Raman amplifier as an amplifier for amplifying the light having a much broader band than by an erbium-doped optical amplifier that has hitherto been employed as the optical amplifier. The Raman amplifier may be defined as a method of amplifying the optical signals, which utilizes such a phenomenon that a gain occurs on the side of frequencies as low as 13THz on the basis of a pumping wavelength due to the stimulated Raman scattering occurred when the pumping beams enter an optical fiber, and, when the signal beams having the wavelength range containing the gain described above are inputted to the optical fiber in the thus excited state, these signals are amplified.

According to the Raman amplification, the signal beams are amplified in a state where a polarization direction of the signal beams is coincident with a polarization direction of the pumping beams, and it is therefore required that an influence by a deviation between polarization directions of the signal beams and of the pumping beams be minimized. For attaining this, a degree of polarization (DOP) has hitherto been reduced by obviating the polarization of the pumping beams, which may be called depolarization.

As a method for obtaining an increased optical output from a pumping light source and simultaneously depolarizing a laser beam emitted therefrom, one in which two laser beams emitted from two semiconductor laser devices oscillating at identical wavelengths are polarization-synthesized by use of a polarization-synthesizing coupler is known, as disclosed in USP5,589,684.

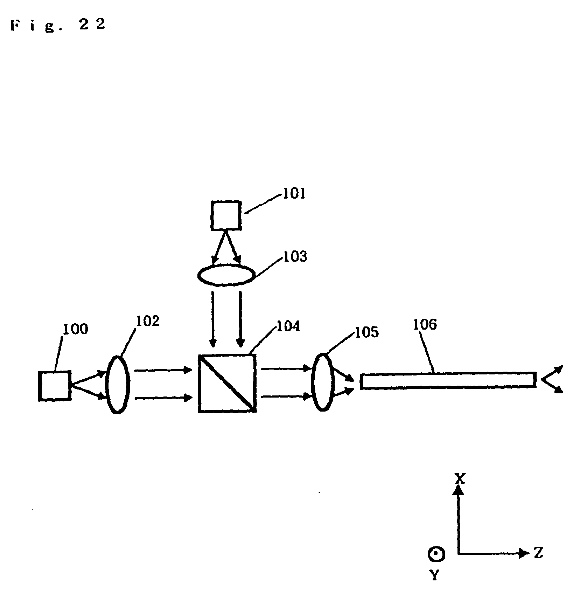

FIG. 22 is an explanatory diagram showing a conventional semiconductor laser apparatus as disclosed in USP5,589,684.

As shown in FIG. 22, the conventional semiconductor laser apparatus comprises a first semiconductor laser device 100 and a second semiconductor laser device 101 emitting laser beams of identical wavelengths in mutually orthogonal directions; a first collimating lens 102 configured to collimate the laser beam emitted from the first semiconductor laser device 100; a second collimating lens 103 configured to collimate the laser beam emitted from the second semiconductor laser device 101; a polarization-synthesizing coupler (i.e. cube beam splitter) 104 configured to polarization-synthesize the laser beams that were collimated by the first collimating lens 102 and the second collimating lens 103; a convergent lens 105 configured to converge the laser beams polarization-synthesized by the polarization-synthesizing coupler 104; and an optical fiber 106 for receiving the laser beams converged by the convergent lens 105 and letting the laser beams travel outside. (This technology will hereinafter be called a prior art.)

In the prior art, the laser beams are emitted from the first semiconductor laser device 100 and the second semiconductor laser device 101 in mutually orthogonal directions and are polarization-synthesized by the polarization-synthesizing coupler 104 to obtain a laser beam of reduced DOP from the optical fiber 106.

Last diode modules for pumping of fibre amplifiers are for example known from US-A-5 291 571 or US-A-5 692 082.

In addition, the applicant of the present invention has proposed a semiconductor laser module in which two laser beams emitted from a single semiconductor laser device having two stripes are polarization-synthesized and received by an optical fiber. (See Japanese patent application No. 2001-402819, for example. This technology will hereinafter be called a related art.)

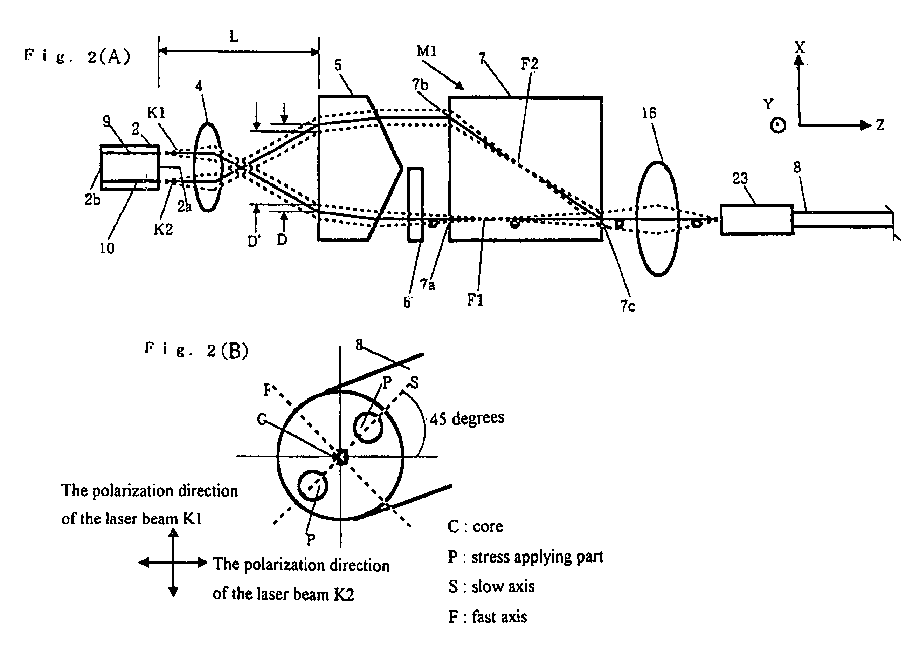

FIG. 2(A) is an explanatory diagram schematically showing a configuration of the semiconductor laser module of the related art.

As shown in FIG. 2(A), the semiconductor laser module M1 of the related art includes a single semiconductor laser device 2 having a first stripe (a light-emitting stripe) 9 and a second stripe 10 formed with a spacing interposed therebetween and emitting a first laser beam K1 and a second laser beam K2 from a front end face (i.e. an end face on right-hand side in FIG. 2(A)) of the first stripe 9 and the second stripe 10 respectively; a first lens 4 configured such that the first laser beam K 1 and the second laser beam K2 are incident therealong and separated in the direction in which the first and second stripes 9, 10 are arrayed; a half-wave plate 6 configured to rotate a polarization direction of at least one of the first and second laser beam K1, K2 (i.e. the first laser beam K1 in FIG. 2(A)) by a predetermined angle (by 90 degrees, for example); a PBC (polarization beam combiner) 7 configured to optically synthesize therealong the first laser beam K1 and the second laser beam K2; and an optical fiber 8 for receiving the laser beams emerging from the PBC 7 and letting the beams to travel outside.

In addition, a prism 5 is disposed between the first lens 4 and the half-wave plate 6 so that the first laser beam K1 and the second laser beam K2 are incident thereon and output therefrom along their respective optical axes parallel to each other. Further, a second lens 16 is disposed between the PBC 7 and the optical fiber 8 in order to optically couple the first and second laser beams K1, K2 polarization-synthesized by the PBC 7 to the optical fiber 8.

The first laser beam K1 and the second laser beam K2 emitted respectively from the front end face 2a of the first stripe 9 and the second stripe 10 of the semiconductor laser device 2 travel through the first lens 4, intersect and separate until the separation between the two beams is enough, before entering the prism 5.

The first laser beam K1 and the second laser beam K2 are made parallel to each other during propagation through the prism 5, and are output from there. The first laser beam K1 then enters the half-wave plate 6, where its polarization direction is rotated by 90 degrees, and then enters a first input port 7a of the PBC 7, while the second laser beam K2 enters a second input port 7b of the PBC 7.

The first laser beam K1 incident on the first input port 7a and the second laser beam K2 incident on the second input port 7b are synthesized along the PBC 7, and output from an output port 7c.

The laser beams emerging from the PBC 7 are then converged by the second lens 16, enter an end face of the optical fiber 8 supported by the ferrule 23, and propagate to outside.

In the prior art, the difference in intensities of the output laser beams, in their coupling efficiency to the optical fiber or in some other respects between the first semiconductor laser device 100 and the second semiconductor laser device 101 sometimes results in an insufficiently decreased value of DOP of the polarization-synthesized laser beams coupled to the optical fiber 107.

In addition, in the semiconductor laser module of the related art, intensities of the laser beams coupled to the optical fiber 8 differ between K1 and K2, because (1) the beams K1, K2 experience different amounts of attenuation due to only one (K1) of the laser beams traveling through the half wave plate 6 and due to the laser beams K1, K2 propagating along different optical path lengths to the optical fiber 8, or (2) because the laser beams K1, K2 are focused at different positions on the optical downstream of the second lens 16 (namely, the beam waists of the respective laser beams formed by the second lens 16 fail to coincide) on account of a difference of the optical path lengths propagated by the laser beams K1, K2 to the optical fiber 8. For this reason, the degree of polarization (DOP) of the laser beam coupled to the optical fiber 8 is sometimes insufficiently decreased.

Furthermore, both in the semiconductor laser module of the prior art and in that of the related art, a change in the optical coupling efficiency to the optical fiber 8 of each laser beams, which might occur due to a change in ambient temperature or the like, sometimes results in fluctuation of DOP of the synthesized laser beam obtained through the optical fiber 8.

This and other problems are solved by the semiconductor laser module according to claim 1 and the Raman amplifier according to claim 4. Further preferred aspects and improvements of the invention are disclosed in the depending claims, the figures and the description.

In particular, it is an object of the present invention to provide a semiconductor laser module capable of further decreasing and stabilizing the DOP of a polarization-synthesized laser beam optically coupled to an optical fiber, an optical amplifier and a method of manufacturing the semiconductor module.

The present invention provides a semiconductor laser module comprising: a semiconductor laser device having a first stripe emitting a first last beam and a second stripe limiting a second last beam; a polarization synthesizer configured to polarization synthesize a first laser beam and a second laser beam emitted from said stripe of said semiconductor laser device; a package accommodating said semiconductor laser device; and an optical fiber for receiving the synthesized laser beam emerging from said polarization synthesizer, wherein said optical fiber is a polarization maintaining fiber, and wherein said optical fiber is fixed to said package in a state that two mutually orthogonal primary axes of said polarization maintaining fiber is oriented at approximately 45 degrees to each of the polarization directions of said first laser beam and said second laser beam.

Each of the stripes of the semiconductor laser device includes a diffraction grating.

The oscillation spectrum of the first laser beam and the oscillation spectrum of the second laser beam is avoided to intersect in the range where the intensity difference from the maximum is 3dB or less.

The semiconductor laser device may be a single semiconductor laser device comprising a first stripe and a second stripe which are formed with a spacing interposed therebetween, and which emit respectively the first laser beam and the second laser beam from one end face thereof.

The first stripe and the second stripe may be arranged with the spacing of 100 $\mu$m or less.

The present invention also provides a Raman amplifier comprising the above-mentioned semiconductor laser module as a pumping light source.

The following figures and the description thereof exemplarily disclose embodiments according to the invention:

Fig. 1(A) is a side sectional view showing a configuration of a semiconductor laser module in accordance with a first embodiment of the present invention;

Fig. 1(B) is a side view showing a state where a semiconductor laser device is fixed onto a heat sink;

Fig. 2(A) is an explanatory diagram schematically showing a configuarion of an optical system used in the semiconductor laser module of the related art and of the first embodiment of the present invention;

Fig. 2(B) is a sectional view taken at a longitudinal position of an optical fiber, a polarization maintaining fiber, used in the first embodiment of the present invention;

FIG. 3(A) is a side view showing a shape of a prism; FIG. 3(B) is a plan view thereof;

FIG. 4(A) is a plan sectional view of a polarization-synthesizing module taken along the line A-A in FIG. 4(B); FIG. 4(B) is a side sectional view thereof; FIG. 4(C) is a front view thereof; FIG. 4(D) is a perspective view thereof;

FIG. 5 is an explanatory diagram showing an alignment method of the optical fiber in the embodiments of the present invention;

FIG. 6 is an explanatory diagram showing a modified example of the semiconductor laser device in the embodiments of the present invention;

FIG. 7(A) and (B) are explanatory diagrams showing an alignment process of the first lens.

FIG. 8(A) and (B) are explanatory diagrams showing a structure of a semiconductor laser device, of which FIG. 8 (B) is a cross sectional diagram taken along the line a-a in FIG. 8(A);

FIG. 9 is an explanatory diagram showing another example of the semiconductor laser device;

FIG. 10 is an explanatory diagram schematically showing a configuration of a modified example of the semiconductor laser module in accordance with the embodiment of the present invention;

FIG. 11 is an explanatory diagram schematically showing a configuration of a modified example of the semiconductor laser module in accordance with the embodiment of the present invention;

FIG. 12 is an explanatory diagram schematically showing a configuration of a modified example of the semiconductor laser module in accordance with the embodiment of the present invention;

FIG. 13 is an explanatory diagram schematically showing a configuration of a modified example of the semiconductor laser module in accordance with the embodiment of the present invention;

FIG. 14(A) to (C) are explanatory diagrams showing a structure of a semiconductor laser device used in a semiconductor laser module in accordance with a first embodiment of the present invention, of which FIG. 14(B) and (C) are cross sectional diagrams taken respectively along the line b-b and c-c in FIG. 14(A);

FIG. 15 is a graph showing a relation between the oscillation spectrum and longitudinal modes of the semiconductor laser device used in the semiconductor laser module in accordance with the first embodiment of the present invention;

FIG. 16(A) and (B) are diagrams showing a relation between the intensity of the longitudinal modes and the threshold of stimulated Brillouin scattering for the cases of single longitudinal mode oscillation and of multi longitudinal mode oscillation, respectively;

FIG. 17 is a graph showing an optical intensity to wavelength characteristics for explaining the first embodiment of the present invention;

FIG. 18 is a graph showing an optical intensity to wavelength characteristics for explaining the first embodiment of the present invention;

FIG. 19 is an explanatory diagram schematically showing a configuration of a semiconductor laser module in accordance with a second example useful for the understanding of the present invention;

FIG. 20 is an explanatory diagram schematically showing a configuration of a semiconductor laser module in accordance with a third example useful for the understanding of the present invention;

FIG. 21 is a block diagram showing a configuration of a Raman amplifier in accordance with a second embodiment of the present invention;

FIG. 22 is an explanatory diagram showing a conventional semiconductor laser apparatus as disclosed in USP5,589,684.

Embodiments of the present invention will hereinafter be described with reference to the accompanying drawings.

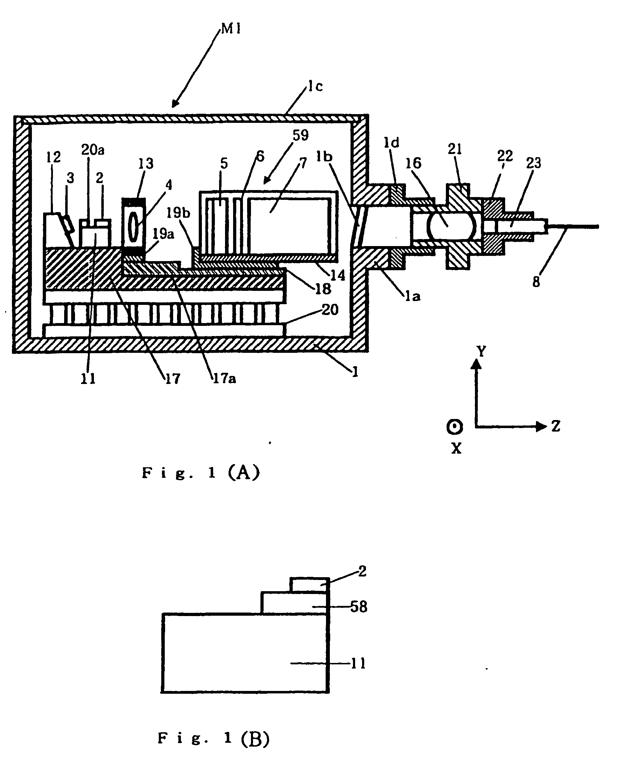

FIG. 1(A) is a side sectional view showing a configuration of a semiconductor laser module in accordance with a first embodiment of the present invention, and FIG. 2 is an explanatory diagram schematically showing a configuration of the semiconductor laser module example useful for the understanding of the present invention.

As shown in FIG. 1(A), the semiconductor laser module M1 example useful for the understanding of the present invention has a package 1 hermetically sealing the internal space thereof, a semiconductor laser device 2 disposed in the package 1 and emitting laser beams, a photo diode (light-receiving element) 3, a first lens 4, a prism 5, a half wave plate (polarization rotator) 6, a PBC (polarization beam combiner) as an optical synthesizer, and an optical fiber (polarization maintaining fiber) 8.

As shown in FIG. 2, the semiconductor laser device 2 has a first stripe 9 and a second stripe 10 formed coplanarly and extending in parallel to each other along their longitudinal directions with a spacing interposed therebetween, and a first laser beam K1 and a second laser beam K2 are emitted respectively from end faces of the first stripe 9 and the second stripe 10. The symbols K1 and K2 in FIG. 2 represent trajectories of centers of the laser beams emitted from the first and second stripe 9 and 10, respectively. The laser beams travels with some spread about their respective centers, as indicated by broken lines in FIG. 2. For the purpose of letting the beams K1 and K2 be incident on a single first lens 4, the spacing between the first stripe 9 and the second stripe is set to $100\mu$m or smaller, or about 40 to $60\mu$m for instance. The narrow spacing between the stripes makes the difference of optical output characteristics between the stripes less significant.

As shown in FIG. 1(A), the semiconductor laser device 2 is fixedly fitted onto a chip carrier 11. Note that the semiconductor laser device 2 emits the two laser beams K 1 and K2, and is therefore more exothermic than a semiconductor laser device emitting a single laser beam. It is hence preferable that the semiconductor laser device 2 be fixedly fitted onto a heat sink 58 formed of a high thermal conductivity material such as diamond or so forth, which is fixedly fitted onto the chip carrier 11.

The photodiode 3 receives laser beams for monitoring, which are emitted from a rear (left side in FIG. 1(A)) end face 2b of the semiconductor laser device 2 (see FIG. 2). The photodiode 3 is fixedly attached to a photodiode carrier 12.

The first lens 4, on which the first laser beam K1 and the second laser beam K2 emitted from a front (right side in FIG. 1(A)) end face 2a of the semiconductor laser device 2 are incident (see FIG. 2), functions so that the laser beams K1, K2 intersect each other, split afterwards in the direction in which the stripes 9, 10 are arrayed, with their spacing increasing as they travel, and are focused at different positions (F1, F2), respectively: i.e. so that they form respective beam waists (see FIG. 2).

Normally, if the beams are transformed into collimated beams with large spots, angular deviation in the optical components of only 0.1 degrees or smaller is tolerated. However, if the beams are propagated in a form of convergent beams, more angular deviation can be tolerated. Using the first lens 4 as a convergent lens is therefore preferable in slackening the tolerance imposed during the manufacturing, alignment and angular alignment of the optical components.

In addition, using the first lens 4 as a convergent lens in this way, helps reduce the spot sizes of the propagating laser beams, which enables downsizing of optical components used.

As shown in FIG. 1(A), the first lens 4 is held by a first lens holding member 13. Preferably, the first lens 4 is aligned such that the optical axes of the first laser beam K 1 emitted from the first stripe 9 and the second laser beam K2 emitted from the second stripe 10 are symmetric with respect to a center axis thereof. The configuration allows both of the first laser beam K1 and the second laser beam K2 to propagate near the central region of small aberration, leading to less perturbations being added onto wave fronts of the laser beams and thereby increasing the coupling efficiency to the polarization maintaining fiber 8. Consequently, the semiconductor laser module M1 with increased optical output can be provided. Note that the first lens 4 may preferably be an aspheric lens in order to obviate an adverse effect of spherical aberrations and thereby to attain a higher coupling efficiency.

The prism 5 is disposed between the first lens 4 and the PBC 7, in order to correct the optical paths of the first laser beam K1 and the second laser beam K2 incident thereon such that the two beams exit the prism along their respective optical axes parallel to each other. The prism 5 may be formed of optical glass such as BK7(borosilicate crown glass). Since the optical axes of the first and second laser beams K1, K2 traveling in non-parallel to each other away from the first lens 4 are made parallel by the refraction of the prism 5, it becomes easy not only to manufacture the PBC 7 disposed downstream of the prism 5 but also to downsize the PBC 7 and thereby to downsize the semiconductor laser module M1.

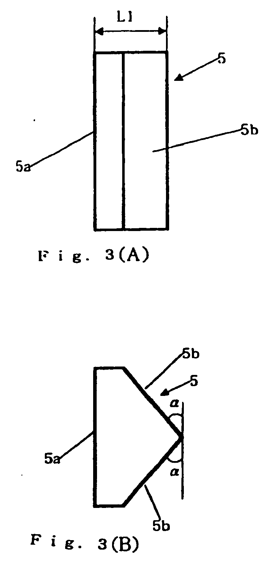

FIG. 3(A) is a side view showing a shape of the prism 5, FIG. 3(B) is a plan view thereof. As shown in FIG. 3, the prism 5 includes a flat incident surface 5a and exit surfaces 5b inclined at a predetermined angle $\alpha$. The prism 5 may be about 1.0mm in total length L1 and the angle $\alpha$ thereof may be 3.2E0.1 degrees for the case of the prism 5 being made of BK7, with the spacing between the stripes of the semiconductor laser device being $40\mu$m and the focal length of the first lens 4 being chosen to be 0.7mm.

As shown in FIG. 2, the half wave plate 6 functions as a polarization rotator that receives only the first laser beam K1 of the first and second laser beam K1, K2 out through the prism 5, and rotates the polarization direction by 90 degrees. Since the first and second laser beams K1, K2 are sufficiently separated by the first lens 4, the half wave plate 6 is easier to dispose.

The PBC 7 includes a first input port 7a on which the first laser beam K1 is incident, a second input port 7b on which the second laser beam K2 is incident, and an output port 7c from which the first laser beam K1 incident on the first input port 7a and the second laser beam K2 incident on the second input port 7b are multiplexed and emitted. For example, the PBC 7 may be a birefringence element that allows the first laser beam K 1 to travel as an ordinary ray to the output port 7c and the second laser beam K2 as an extraordinary ray to the output port 7c. If the PBC 7 is formed by a birefringence element, it may be $TiO_2$ (rutile) for example.

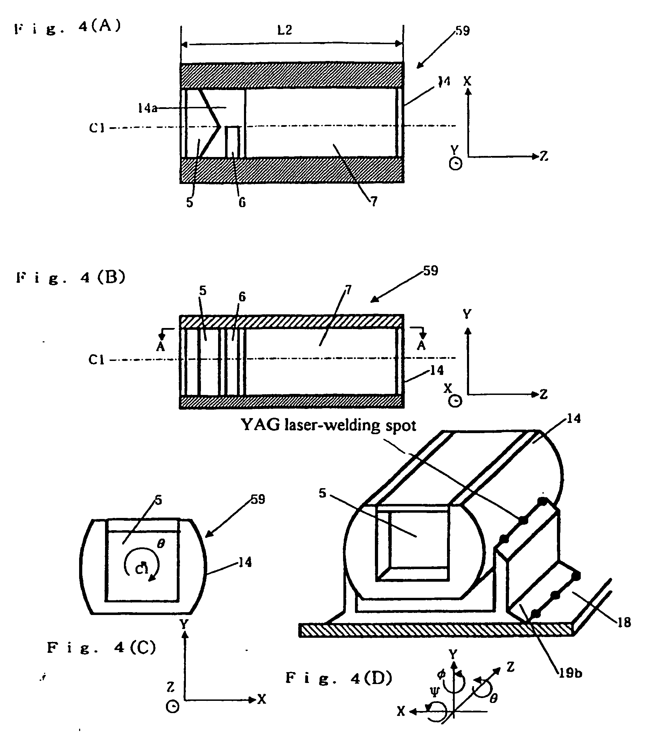

The present example, utilizes a polarization-synthesizing module 59, in which the prism 5, the half wave plate 6 and the PBC 7 are fixedly integrated to a single holder member 14. FIG. 4(A) is a cross sectional view of the polarization-synthesizing module 59 taken along the line A-A in FIG. 4(B), FIG. 4(B) is a side sectional view thereof, FIG. 4(C) is a front view thereof, and FIG. 4(D) is a perspective view illustrated with a second supporting member 19b. The holder member 14 of the polarization-synthesizing module 59 is made of a material suitable for YAG laser welding (SUS403 or 304, for example), about 7.0 mm in total length L2, and the entire shape thereof is formed substantially into a cylinder, as shown in FIG. 4. The holder member 14 has an accommodating portion 14a formed inside thereof, where the prism 5, the half wave plate 6 and the PBC 7 are fixed. The top and bottom portions of the holder member 14 are formed flat.

As shown in FIG. 4(D), the polarization-synthesizing module 59 is placed between two upright walls of a second supporting member 19b having substantially an U-shaped cross section, positioned there in Y, Z, θ(azimuth around Z-axis), and Ψ(azimuth around X-axis) directions, and positioned as well, by being co-moved with the second supporting member 19b, in X and φ (azimuth around Y-axis) directions. In this state, the polarization synthesizing module 59 is fixed by YAG laser-welding to a second substrate 18 (which will be referred to later) through the second supporting member 19b.

The configuration allows easier alignment of the prism 5 and the PBC 7 such that the first laser beam K1 incident on the first input port 7a of the PBC 7 and the second laser beam K2 incident on the second input port 7b are both emitted from the output port 7c.

In addition, if these optical parts are integrated into a single body using the holder member 14 in this way, it is possible to adjust a degree of overlapping of the laser beams K1, K2 at the output port 7c of the PBC 7 simply by moving the holder member 14 through the second support member 19b.

The optical fiber 8 receives the laser beams emerging from the output port 7c of the PBC 7 and transmits them to outside of the package 1.

In the present example, the DOP of the polarization-synthesized laser beam is further decreased by using a polarization maintaining fiber (a birefringence fiber) as the optical fiber 8. That is, as shown in FIG. 2(B), the polarization maintaining fiber 8 is aligned such that the two mutually orthogonal primary axes (i.e. the slow axis S and the fast axis F) thereof are oriented at approximately 45 degrees to the polarization directions of the first laser beam K1 and the second laser beam K2 emitted from the first and second stripes 9, 10 of the semiconductor laser device 2.

The configuration allows the polarization maintaining fiber 8 to function as a depolarizer (depolarizing element) and enables a sufficiently depolarized laser beam to be obtained from an exit end of the polarization maintaining fiber 8 even in the presence of, for example, the imbalance in the intensities of the laser beams K1, K2 coupled to the polarization maintaining fiber 8 that would hinder the DOP of the synthesized beam from being sufficiently small. Thus, the semiconductor laser module of the present embodiment is suitable for use as a pumping light source of Raman amplifiers that require a low polarization dependency in amplification gain.

In addition, in the present example, since the depolarization is achieved to some extent already at the coupling position of the laser beams K1, K2 to the polarization maintaining fiber 8, the length of the polarization maintaining fiber required for depolarization can be shorter and it can be between 3m and 6m or so for example, as compared with the case where a linearly polarized beam is depolarized. Therefore, the configuration is helpful in reducing the cost of equipment.

Between the PBC 7 and the polarization maintaining fiber 8 is disposed a second lens 16 for coupling the laser beams emerging from the output port 7c of the PBC 7 to the polarization maintaining fiber 8. Note that in the embodiment, the first lens 4 is positioned such that the first laser beam K1 and the second laser beam K2 have focused points (F1, F2) between the first lens 4 and the second lens 16. The configuration allows spot sizes of the laser beams between the first lens 4 and the focused points (F1, F2) to be smaller and prevents overlapping of the beams, reducing the propagation length L (see FIG. 2(A)) necessary for the separation D' between the first laser beam K1 and the second laser beam K2 to be large enough to permit the half wave plate 6 to be inserted only on the optical path of the first laser beam K1. Hence, a length of the semiconductor laser module M 1 along the optical axis can be smaller, and consequently, it is possible to provide a highly reliable semiconductor laser module with superior stability over time of optical coupling between the semiconductor laser device 2 and the polarization maintaining fiber 8 in a high temperature environment.

In addition, since the spot sizes of the laser beams between the first lens 4 and the second lens 16 can be smaller, it is also possible to downside the optical components used there.

As shown in FIG. 1, a chip carrier I 1 to which the semiconductor laser device 2 is fixed and a photodiode carrier 12 to which a photodiode 3 is fixed, are soldered to a first substrate 17 having an L-shaped cross section. The first substrate 17 is preferably formed of copper-tungsten alloy etc. in order to assure superior dissipation of the heat generated by the semiconductor laser device 2.

A first lens holding member 13 fixedly holding the first lens 4 and a polarization-synthesizing module 59 in which the prism 5, the half wave plate 6 and the PBC 7 are fixed to the holder member 14, are fixed by YAG laser-welding to a second substrate 18 made of stainless steel blazed in advance onto a flat portion 17a of the first substrate 17, respectively through a first supporting member 19a and a second supporting member 19b.

Beneath the first substrate is disposed a cooler 20 comprising peltier elements. The temperature rise by the heat generation of the semiconductor laser device 2 is detected by a thermistor 20a disposed on the chip carrier 11, while the cooler 20 is controlled such that the temperature detected by the thermistor 20a is kept at a predetermined value. In this way, the intensity of the laser emission from the semiconductor laser device 2 is increased and stabilized.

Inside a flange 1a formed on a side of the package 1, a window 1b for allowing the beams that have passed through the PBC 7 to be incident on is disposed. In addition, the second lens 16 for converging the laser beams is fixed to an end of the flange 1a. The second lens 16 is held by a second lens holding member 21 which is YAG laser-welded to the end of the flange 1a, and a ferrule 23 holding the polarization maintaining fiber 8 is YAG laser-welded to an end of the second lens holding member 21 through a metal slide ring 22.

Next, the operation of the semiconductor laser module M1 according to the first example useful for the understanding of the present invention will be explained below.

As shown in FIG. 2, the first laser beam K1 and the second laser beam K2, being respectively emitted from the front end faces 2a of the first stripe 9 and the second stripe 10 of the semiconductor laser device 2, travel through the first lens 4, intersect each other and thereafter, separate until the separation between the two beams are enough, and enters the prism 5. On entering the prism 5, the separation (D) between the first laser beam K 1 and the second laser beam K2 is about $460\mu$m. The first laser beam K1 and the second laser beam K2 are made parallel to each other through the prism 5 and emitted in that state (with their separation being enlarged to about $500\mu$m). Then, the first laser beam K1 enters the half wave plate 6, where it experiences rotation of its polarization direction by 90 degrees, and enters the first input port 7a of the PBC 7, while the second laser beam K2 enters the second input port 7b of the PBC 7.

The first laser beam K1 entering the first input port 7a and the second laser beam K2 entering the second input port 7b are multiplexed along the PBC 7 and emitted from the output port 7c.

The laser beams emerging from the PBC 7 are then converged by the second lens 16 and made incident on the end face of the polarization maintaining fiber 8 which has been fixed such that the two primary axes thereof are oriented approximately 45 degrees to the polarization directions of the first and second laser beams, and propagate therein.

Thus, the synthesized laser beam is depolarized during the propagation through the polarization maintaining fiber 8, and consequently, a sufficiently depolarized laser beam can be obtained from an exit end of the polarization maintaining fiber even in the presence of adverse factors such as the imbalance in intensities of the laser beams K1, K2 coupled to the polarization maintaining fiber 8 that hinders the DOP of the synthesized beam from being sufficiently small at the input end of the polarization maintaining fiber 8.

The semiconductor laser module M1 with such configuration can emit a laser beam of high intensity and of decreased degree of polarization, and hence, can be preferably used as a pumping light source of Raman amplifiers.

Note that since the semiconductor laser module M1 of the present example has a single semiconductor laser device 2 with two stripes and a single first lens 4 for separating two laser beams K1, K2, the time required for alignment of the semiconductor laser device 2 and the first lens 4 can be shortened. Thus the manufacturing time of the semiconductor laser module M1 can be shortened.

Moreover, the two laser beams, being respectively emitted from the two stripes formed with an interval of $100\mu$m or less on the single semiconductor laser device 2, will find little difference in the variation of coupling efficiency to the polarization maintaining fiber 8 induced by the warpage of the package 1 that may occur in the direction perpendicular to the stripes (i.e. in X direction in FIG. 1). Hence, adverse effects of the warpage of the package 1 can be limited to only in the axial direction of the polarization maintaining fiber 8 (in Z direction in FIG. 1), making the optical output and the degree of polarization from the semiconductor laser module more stable against the warpage of the package 1. Furthermore, since the two stripes 9, 10 are formed with the spacing of $100\mu$m or less on the single semiconductor laser device 2, the number of semiconductor laser devices obtained from a single semiconductor wafer can be large, which is helpful in reducing cost.

In addition, since the semiconductor laser module M1 uses a single semiconductor laser device 2, it is easy to downsize the cooler 20 such as a Peltier module for cooling the heat generated by the semiconductor laser device 2, which is advantageous in reducing the electric power consumption.

Next, the manufacturing method of the semiconductor laser module M1 according to the first example useful for the understanding of the present invention is described.

First, a chip carrier 11 to which a semiconductor laser device 2 is fixed and a photodiode carrier 12 to which a photodiode 3 is fixed , are soldered to a first substrate 17.

Then, a first lens 4 is aligned on a second substrate 18 which has been blazed in advance onto the first substrate 17, and fixed thereto. In aligning the first lens 4, both of the first laser beam K1 and the second laser beam K2 are emitted from the first stripe 9 and the second stripe 10 of the semiconductor laser device 2 by supplying an electric current to the semiconductor laser device 2, and the direction of their emission is set as a fiducial direction. Thereafter, the first lens is inserted and positioned in each of X, Y, and Z directions.

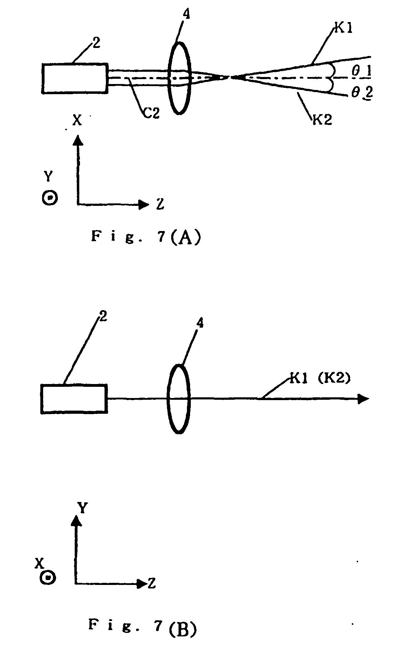

FIG. 7 is an explanatory diagram showing an alignment process of the first lens 4. As shown in FIG. 7(A), the first lens 4 is positioned in the X-axis direction such that the angle $\theta 1$ made between the fiducial direction (i.e. a central axis C2) set in the above-described way and the first laser beam K1 is equal to the angle $\theta 2$ made between the central axis C2 and the second laser beam K2. In the Y-axis direction, the first lens 4 is positioned such that the first laser beam K1 and the second laser beam K2 travel on the central axis of the first lens 4, as shown in FIG. 7(B). And in Z-axis direction, the first lens 4 is positioned such that the laser beams have minimal spot diameters at a predetermined distance away from the semiconductor laser device 2. Preferably, the first lens 4 is positioned in the Z-axis direction such that each of the laser beams emerging from the first lens 4 has a minimal spot diameter at a predetermined position between the first lens 4 and the second lens 16. The first lens holding member 13 holding the first lens 4 which has been aligned in the above-described way, is then fixed to the second substrate 18 by YAG laser-welding through a first supporting member 19a.

Thereafter, a polarization-synthesizing module 59 in which a prism 5, a half wave plate 6 and a PBC 7 are integrated, is aligned on the second substrate 18 and fixed thereto. In aligning the polarization-synthesizing module 59, a dummy fiber for alignment (i.e. a fiber with lens, unillustrated) is positioned so as to receive the synthesized beam emerging from the output port 7c of the PBC 7. Then, the holder member 14 is positioned in each of X, Y, Z, θ(azimuth around Z-axis), φ(azimuth around Y-axis), and Ψ(azimuth around X-axis) directions, such that the optical power coupled to the dummy fiber is maximized. In doing so, as shown in FIG. 4(D), the holder member 14 is placed between two upright walls of a second supporting member 19b having substantially an U-shape in cross section, and positioned in each of Y, Z, θ, and Ψ directions and positioned as well, being co-moved with the second supporting member 19b, in X and φ directions.

The alignment of the polarization-synthesizing module 59 having been finished in this way, the second supporting member 19b is then YAG laser-welded to the second substrate 18 as shown in FIG. 4(D), followed by the holder member 14 being YAG laser-welded to the upright walls of the second supporting member 19b. Thus, the holder member 14 is fixed to the second substrate 18.

Then, the first substrate 17 is positioned on the cooler 20 which in advance has been fixed on a bottom plate of a package 1, such that the laser beam emerging from the output port 7c of the PBC 7 travels in the middle of the flange 1a of the package 1. Thereafter, the first substrate 17 is fixed there by soldering.

Then, the semiconductor laser device 2 and the photodiode 3 for monitoring are electrically connected to leads (unillustrated) of the package 1 through gold wires (unillustrated).

A lid 1c is then placed on an upper end of the package 1 in an inert gas (such as $N_2$ or Xe) atmosphere, in which the package is hermetically sealed by resistance-welding the peripheral edge of the lid.

Thereafter, a second lens 16 is positioned in X-Y plane and in Z direction on the flange 1a of the package 1, and fixed there. In this step, the second lens holding member 21, being inserted into a slide ring 1d, is moved on an edge surface of the flange 1a, until the laser beam emerging from the second lens 16 is parallel to the central axis of the flange 1a of the package 1 (which is in parallel to Z-axis). The slide ring 1d is then YAG laser-welded to the edge of the flange 1a. Thereafter, the second lens holding member 21 is moved along Z-axis direction, while monitoring the divergence angle of the beam emerging from the second lens 16, until the divergence angle substantially matches with a numerical aperture (NA) of the polarization maintaining fiber 8. The second lens holding member 21 and the slide ring 1d are then YAG laser-welded together.

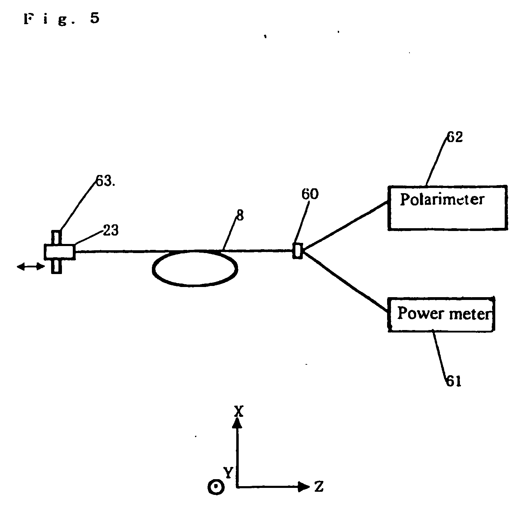

In the final step, the polarization maintaining fiber 8 is aligned and fixed. In this step, in the first place, a power meter 61 and a polarimeter 62 are connected to an end portion of the polarization maintaining fiber 8 through a connector 60, as shown in FIG. 5.

Then, a ferrule 23, being inserted into a slide ring 22, is held by ferrule alignment hands 63. In this state, the ferrule 23 is positioned in the plane orthogonal to the optical axis of the polarization maintaining fiber 8 (i.e. in X-Y plane) and in the direction along the optical axis of the polarization maintaining fiber 8 (i.e. in Z direction), such that the intensity of the beam measured by the power meter 61 is maximized.

Thereafter, the polarization maintaining fiber 8 is rotated around a central axis thereof, while measuring the DOP of the synthesized beam through the polarimeter 62, until the DOP is minimized or until the DOP becomes less than a predetermined value (8%, or preferably, 5%). When the alignment is finished, the two primary axes of the polarization maintaining fiber 8 are oriented at 45 degrees to the polarization directions of the two laser beams K1, K2.

The alignment of the polarization maintaining fiber 8 having been finished in this way, the ferrule 23 is then fixed to the slide ring 22 by YAG laser-welding at its interior. Thereafter, the slide ring 22 and the second lens holding member 21 are fixed together by YAG laser-welding at their boundary. Thus, the assembly of the semiconductor laser module M1 is finished.

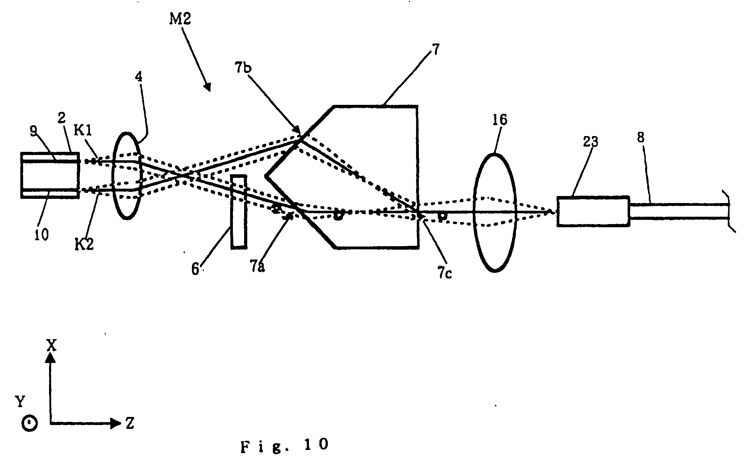

Note that, the semiconductor laser module according to the present invention is not limited to the one configured as above-described. For example, it may be a semiconductor laser module M2 as shown in FIG. 10, in which the first laser beam K1 and the second laser beam K2 are incident in non-parallel to each other on the PBC 7, the input end face of which being formed in wedge-shape such that the first laser beam K1 travels as an ordinary ray along an axial direction of the polarization maintaining fiber 8 and that the second laser beam K2 travels as an extraordinary ray and is emitted in parallel with the optical axis of the polarization maintaining fiber from the output port 7c of the PBC 7 along with the first laser beam K1.

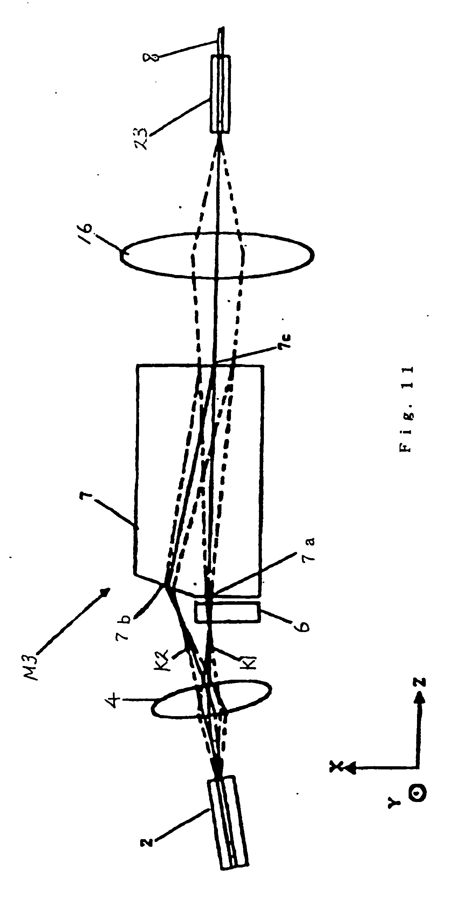

It may also be a semiconductor laser module M3 as shown in FIG. 11, in which the semiconductor laser device 2 and the first lens 4 are disposed with tilts at a predetermined angle to the axial direction of the polarization maintaining fiber 8 such that the laser beam K1 emerged from the first lens 4 travels along the axial direction of the polarization maintaining fiber 8, and in which the second input port 7b of the PBC 7 is inclined with respect to the first input port 7a.

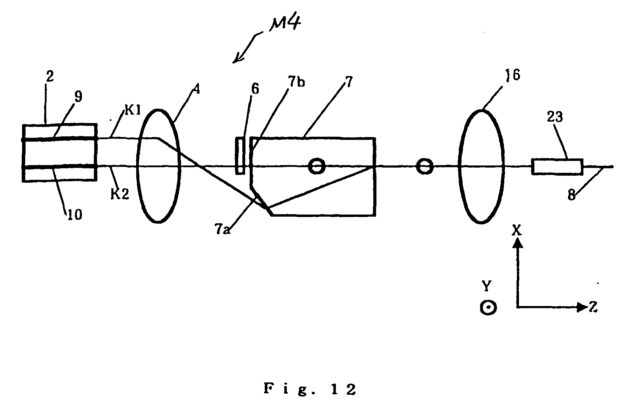

Further, it may be a semiconductor laser module M4 as shown in FIG. 12, in which the first lens 4 is positioned such that the second laser beam K2 travels almost on the central axis of the first lens, and in which the first input port 7a is inclined with respect to the second input port 7b such that the second laser beam K2 travels in parallel with the axial direction of the polarization maintaining fiber 8 and that the first laser beam K1 is emitted from the output port 7c along with the second laser beam K2.

The above described semiconductor laser modules M2 to M4, since there is no prism 5 disposed between the half wave plate 6 and the first lens 4, can be simpler in structure and shorter in length along the optical axis, leading to a mitigation of adverse effects of a warpage of the package on the optical output characteristics in a high temperature environment.

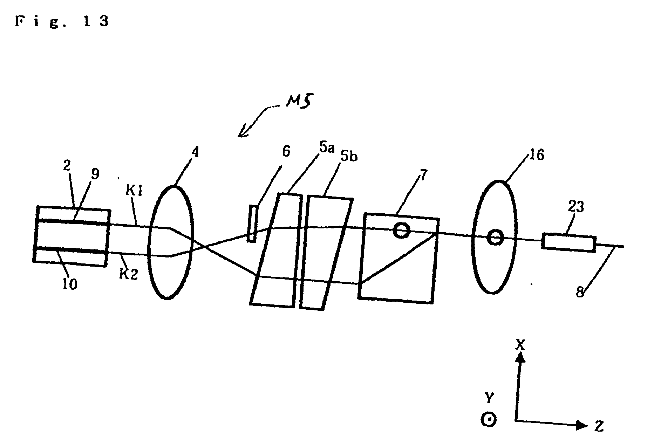

Still further, the semiconductor laser module according to the present invention may be a semiconductor laser module M5 as shown in FIG. 13, in which a plurality (i.e. two, in FIG. 13) of wedge-shaped prisms 5a, 5b are disposed along the optical axis so that laser beams K1, K2 emerging from the first lens 4 are made parallel to each other. In this embodiment, it is easy to make the two laser beams K1, K2 precisely parallel to each other.

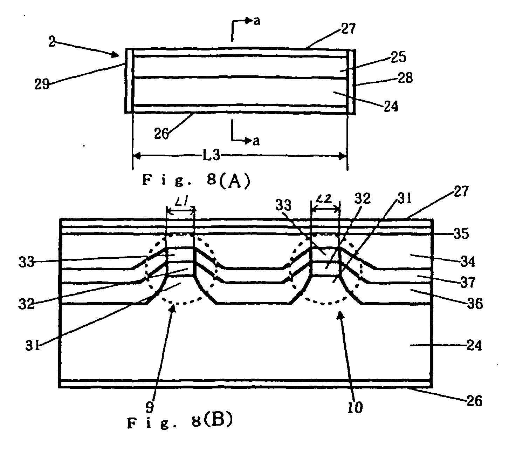

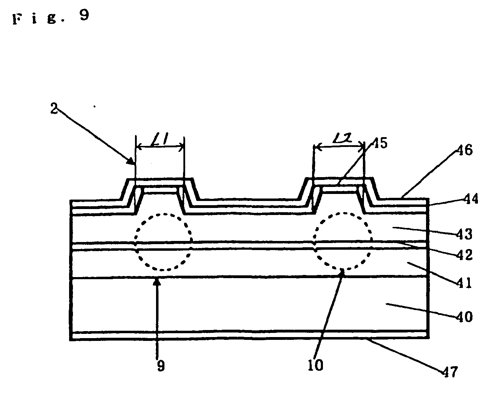

The semiconductor laser device 2 used in the semiconductor laser module according to the present invention will be explained hereinbelow. FIG. 8(A), (B) are explanatory diagrams showing a structure of the semiconductor laser device 2 used in the semiconductor laser module of the present invention, FIG. 9 is an explanatory diagram showing another example of the semiconductor laser device 2. Note that FIG. 8(B) is a cross sectional diagram taken along the line a-a in FIG. 8(A).

As shown in FIG. 8(A), the semiconductor laser device 2 has a lamination structure 25 of predetermined semiconductor materials formed on a substrate 24 by a known epitaxial growth technique such as the metal organic chemical vapor deposition, liquid phase epitaxy, molecular beam epitaxy, or gas source molecular beam epitaxy. A lower electrode 26 is formed on an undersurface of the substrate 24 and an upper electrode 27 is formed on the lamination structure 25, and thereafter, the lamination structure is cleaved to form a cavity of a predetermined length L3. Then, a low reflection layer 28 (with reflectance less than or equal to 5%, for instance) is formed on its one cleaved facet (front end face 2a), and a high reflection layer 29 (with reflectance greater than or equal to 90%, for instance) is formed on the other cleaved facet (rear end face 2b).

As shown in FIG. 8(B), the lamination structure 25 on the substrate 24 is, for instance, of a BH structure (buried heterostructure) including for instance an InP substrate 24 and stacked layers of e.g. an n-InP clad layer 31, an active layer 32 consisting of e.g. a GRIN-SCH-MQW (Graded Index Separate Confinement Heterostructure Multi Quantum Well) composed of multilayers of GaInAsP, and e.g. a p-InP clad layer 33, which are sequentially stacked in this order. The lamination structure 25 further includes an upper buried layer 34 composed of e.g. p-InP and a cap layer 35 composed of e.g. p-GaInAsP, which are stacked on the p-InP clad layer 33. In addition, the upper electrode 27 is formed on the cap layer 35 and the lower electrode 26 is formed on the undersurface of the substrate 24.

Then, the lower n-InP clad layer 31, the active layer 32 and the p-InP clad layer 33 are formed into two ridges of stripes arranged in parallel with each other with a spacing of 40 to 60μm interposed. A p-InP blocking layer 36 and an n-InP blocking layer 37 stacked in this order on the side faces of the ridges define a current confinement region to the active layer 32.

For the purpose of increasing optical output, the active layer 32 preferably involves compressive strain quantum wells with a lattice mismatch of well layers with respect to the substrate 24 within the range between 0.5% and 1.5%, formed in a multi quantum well structure of well number of five or so. Further, a larger value in lattice mismatch in the well layers can be tolerated if a strain compensation structure in which barrier layers have tensile strains opposite to the strains of well layers are adopted in the strained quantum well structure in order for the lattice matching to be equivalently realized.

According to the first example the light-emitting portions, comprising the lower n-InP clad layer 31, the GRIN-SCH-MQW active layer 32 and the p-InP clad layer 33, are formed as stripes extending in a direction vertical to the sheet surface in FIG. 8(B). These portions are called stripes 9 and 10, respectively.

As shown in FIG. 1(B), the semiconductor laser device 2 is bonded to the heat sink 58 at its upper electrode 27 by use of AuSn solder, etc. Thus, the two stripes are capable of simultaneously oscillating and emitting two laser beams through the low reflection layer 28 when being externally supplied with a current through the upper electrode 27 (i.e. p-side in the present embodiment) and the lower electrode 26 (i.e. n-side in the present embodiment).

Here, if the two stripes have completely the same characteristics, then a threshold current of the semiconductor laser device 2 in the present embodiment is twice the threshold current of one stripe, and the total optical output is twice the optical output from one stripe. Namely, the semiconductor laser device 2 as a whole, outputs twice as much optical power at approximately twice as much current as one stripe, with the slope efficiency being unchanged from the case where the semiconductor laser device has only a single stripe.

Note that the semiconductor laser device 2 described in the above first example has been exemplified as having the InP-based BH structure. However, the semiconductor laser device 2 may be of a GaAs-based ridge waveguide type as shown in FIG. 9. In FIG. 9, the semiconductor laser device 2 has a lower n-clad layer 41, an active layer 42, an upper p-clad layer 43, an insulation layer 44, and a p-GaAs layer 45 laminated on a substrate 40 composed of n-GaAs, and two ridges are formed therein. An upper electrode (p-side electrode) 46 is formed on the insulation layer 44 and p-GaAs layer 45, and a lower electrode (n-side electrode) 47 is formed on an undersurface of the substrate 40.

The ridges are formed as stripes extending in a direction vertical to the sheet surface in FIG. 9, and it is the portions of the active layers 42 just beneath the ridges that emit lights. These light-emitting portions are called stripes 9 and 10, respectively. It is needless to say that the ridge LD can be realized in InP-based material.

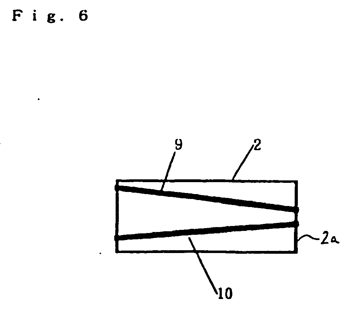

In the above-described semiconductor laser device 2, the first stripe 9 and the second stripe 10 are extending in parallel to each other in the longitudinal direction. However, the stripes are not necessarily arranged as such, but may be slanted as shown in FIG. 6. In FIG. 6, the laser beams are emitted rightward, and the space between the stripes 9 and 10 becomes narrower as it gets closer to the right side edge. Such an arrangement of the stripes allows the two laser beams emitted from the two stripes 9, 10 to intersect at a position closer to the semiconductor laser device 2, and help reduce the length (denoted L in FIG. 2) necessary for the first laser beam K1 and the second laser beam K2, having passed through the first lens 4, to propagate until their separation is large enough to permit a half wave plate 6 to be inserted only on the optical path of the first laser beam K1 (i.e. until D' in FIG. 2 is sufficiently large). Therefore, it is possible to provide a semiconductor laser module M of a reduced length along its optical axis.

Note that the propagation length L can be reduced likewise when the stripes are slanted contrarily to those in FIG. 6, namely, in such a manner that the space between the stripes 9 and 10 becomes wider as it gets closer to the right side edge.

(First embodiment)

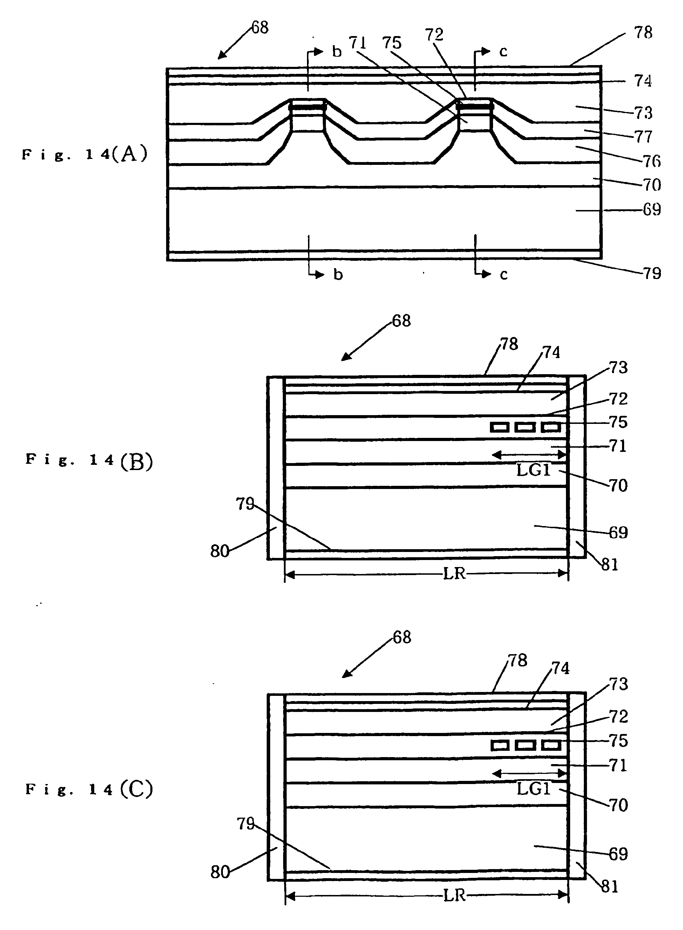

FIG. 14(A) to (C) shows a semiconductor laser device 68 used in the semiconductor laser module in accordance with a first embodiment of the present invention, with a different structure from that of the semiconductor laser device 2 shown in FIG. 8. FIG. 14(B) and (C) are cross sectional diagrams taken along the lines b-b and c-c, respectively, in FIG. 14(A).

In the first embodiment, the wavelengths of the laser beams K1, K2 emitted from the stripes are stabilized by forming a diffraction grating 75 that select a wavelength of light around a predetermined center wavelength $\lambda_0$ within each of the stripes of the semiconductor laser device 68.

As shown in FIG. 14, the semiconductor laser device 68 of the first embodiment has a lamination structure in which an n-InP layer 70 serving both as a buffer layer and as a lower clad layer, a GRIN-SCH-MQW active layer 71, a p-InP clad layer 72, a p-InP buried layer 73, and a GaInAsP cap layer 74 are sequentially stacked on a (100) surface of an InP substrate 69.

Within each of the stripes 9 and 10, a diffraction grating 75 is formed by periodically arranging 20nm-thick p-InGaAs layers with a predetermined pitch. The diffraction grating 75 is formed over a predetermined length LG1 extending from a second reflection layer 81 having a reflectance of as low as 2% or less, preferably 1% or less, still preferably 0.2% or less, toward a first reflection layer 80 having a reflectance of as high as 80% or higher, but not formed over the portion other than the predetermined length L1. The diffraction gratings 75 are designed to select laser lights having a center wavelength $\lambda_0$ of 1300nm to 1550nm. In addition, the cavity length $L_R$ of the semiconductor laser device 68 is set to 800$\mu$m or longer. The other constitution of the semiconductor laser device 68 is the same as those of the semiconductor laser device 2 (as shown in FIG. 8).

The light generated in the GRIN-SCH-MQW active layer 71 of the optical cavity formed between the first reflection layer 80 and the second reflection layer 81 is amplified while being repeatedly reflected by the first reflection layer 80 and the second reflection layer 81, until it is emitted as a laser beam through the second reflection layer 81.

It is generally known that mode spacing $\Delta\lambda$ of the longitudinal modes generated by a cavity of a semiconductor laser device is expressed as :

$$\Delta\lambda = \lambda_0{}^2/(2nL_R) ,$$

where n is an equivalent refractive index.

If the oscillation wavelength $\lambda_0$ is set to 1480nm and if the equivalent refractive index is set to 3.5, the longitudinal mode spacing $\Delta\lambda$ is calculated to be approximately 0.3 9nm for the case of the cavity length of 800$\mu$m, and approximately 0.1nm for the cavity length of 3200$\mu$m. That is, the larger the cavity length, the smaller the longitudinal mode spacing $\Delta\lambda$ becomes, which implies generally that the mode selection condition for realizing the single longitudinal mode oscillation becomes strict as the cavity length is increased.

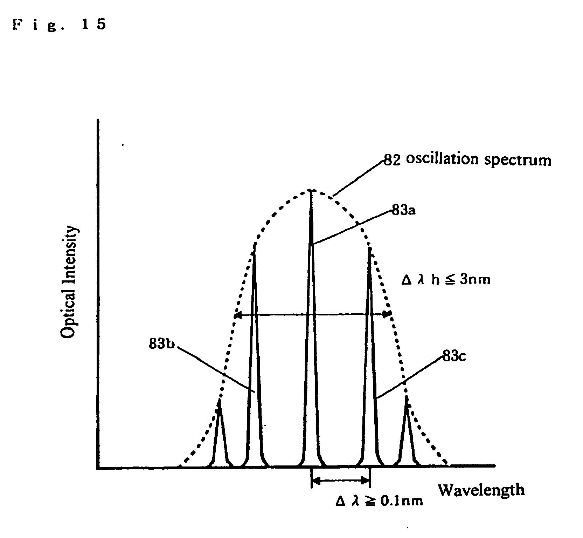

On the other hand, the diffraction gratings 75 formed within the stripes of the semiconductor laser device of the present embodiment select longitudinal modes in accordance with their Bragg wavelengths. The wavelength selection by the diffraction gratings 75 is characterized by the oscillation spectrum 82 as shown in FIG. 15.

In the present embodiment, the semiconductor laser device with the diffraction gratings 75 is designed to oscillate in a plurality of longitudinal modes within the selected wavelength range, represented by a full width at half maximum $\Delta\lambda_h$ of the oscillation spectrum.

Note that the DFB semiconductor laser device or the like known in prior arts has been designed to oscillate in a single longitudinal mode, and the cavity length for that kind of laser has not been selected to be greater than or equal to 800$\mu$m, where a narrow longitudinal mode spacing accounts for a weak mode selectivity and consequent inability to oscillate in a single longitudinal mode. However, the semiconductor laser device 68 of the present embodiment is designed to oscillate in an increased number of longitudinal modes within the full width at half maximum $\Delta\lambda_h$ by positively adopting the cavity length $L_R$ of 800$\mu$m or greater and simultaneously by changing the full width at half maximum $\Delta\lambda_h$ of the oscillation spectrum 82 through changing the length LG1 or a coupling coefficient of the diffraction gratings. Note that FIG. 15 exemplarily shows three longitudinal modes 83a to 83c oscillating within the full width at half maximum $\Delta\lambda_h$ of the oscillation spectrum.

That is, the shorter the coherence length of the laser beam to be depolarized, the shorter the length of the polarization maintaining fiber 8 necessary for the beam to be depolarized can be. The semiconductor laser device 68, having three or more, preferably four or more, of longitudinal modes present in the full width at half maximum of the oscillation spectrum of each of the stripes due to the diffraction grating 75 formed within the waveguide stripes as in the first embodiment, exhibits a shorter coherence length of laser beam than that oscillating in a single longitudinal mode. Hence, utilizing the semiconductor laser device 68 according to the first embodiment enables not only for a wavelength-stabilized laser beam to be obtained but also for the length of a polarization maintaining fiber necessary for depolarization to be shortened. In addition, since the semiconductor laser device 68 of the first embodiment has diffraction gratings 75 within the stripes, it can emit laser beams of reduced relative intensity noise (RIN) as opposed to the case where the oscillation wavelengths are stabilized by a fiber Bragg grating (FBG). Therefore, it can be preferably used as a pumping light source in forward-pumped Raman amplifiers.

Further, in the semiconductor laser device 68, since it has a plurality of longitudinal modes oscillating within a full width at half maximum $\Delta\lambda_h$ of its oscillation spectrum, each of the longitudinal modes carries a lowered intensity of power as compared with the case of the semiconductor laser device oscillating in a single longitudinal mode and emitting the same intensity of optical output as a whole.

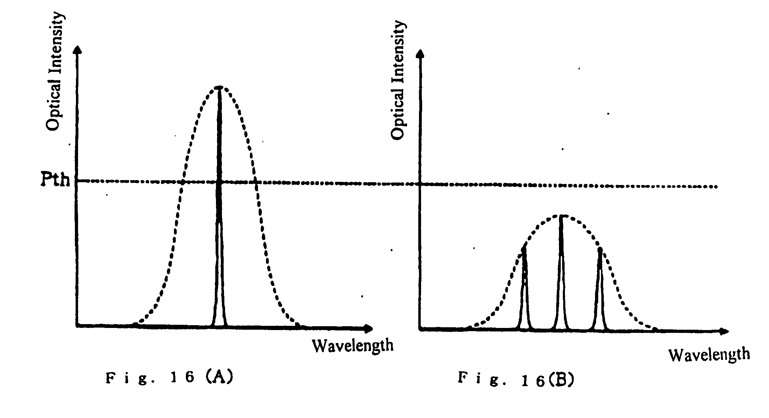

FIG. 16(A) and (B) are diagrams schematically showing longitudinal mode spectra of semiconductor laser devices 68 emitting a light of the same intensity for the cases of the semiconductor laser device oscillating respectively (A) in a single longitudinal mode, and (B) in a plurality of longitudinal modes, where the broken line designated by Pth in the figure marks a threshold for stimulated Brillouin scattering (SBS) to occur (hereinafter called SBS threshold). Since the semiconductor laser device 68 of the first embodiment has a plurality of longitudinal modes oscillating within its full width at half maximum of the oscillation spectrum, the intensity carried by each of the oscillating longitudinal mode can be suppressed to SBS threshold or lower, whereby SBS is prevented from occurring and an amplification with increased gain and reduced noise can result.

Note that, if the semiconductor laser device oscillates in a plurality of longitudinal modes within too wide a spectral width of oscillation, the laser lights may suffer an increased coupling loss at a wavelength-multiplexing coupler, and sometimes an adding of noises or fluctuations of gain due to longitudinal mode hoppings occurred within the oscillation spectrum. For this reason, the full width at half maximum $\Delta\lambda_h$ of the oscillation spectrum 82 is preferably set to 3nm or smaller, or still preferably, 2nm or smaller.

In the semiconductor laser module according to this embodiment, the wavelengths selected by the diffraction gratings are set differently. The polarization maintaining fiber 8 is fixed, being aligned such that each of the polarization directions of the two laser beams K1, K2 of such different wavelengths is oriented at approximately 45 degrees to each of the mutually orthogonal two primary axes of the polarization maintaining fiber 8.

Preferably, the oscillation wavelengths selected by the diffraction gratings formed within the stripes are set mutually different such that the wavelengths of longitudinal modes included in each of the laser beams K1, K2 emitted from the stripes do not overlap at their intense longitudinal modes.

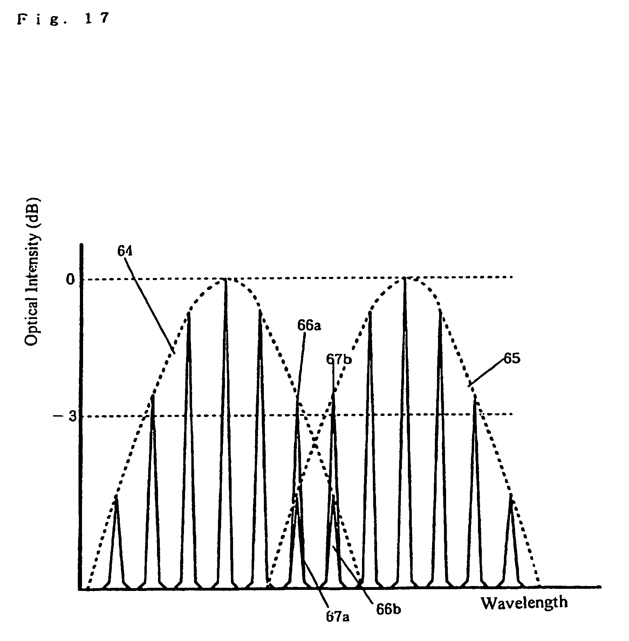

For instance, as shown in FIG. 17, the oscillation wavelengths selected by the diffraction gratings may be set such that the spectral envelopes 64, 65 of the laser beams K1, K2 emitted from the stripes do not overlap on the portions of a predetermined intensity or higher. To be more concrete, the separation of the center wavelengths selected by the diffraction gratings of the stripes is set such that the oscillation spectra 64, 65 do not intersect in the region where the intensity difference down from the maximum intensities of the laser beams is 3dB or less. In the schematic diagram of FIG. 17, although the longitudinal mode 66a belonging to the oscillation spectrum 64 and the longitudinal mode 67a belonging to the oscillation spectrum 65 is overlapping, the intensity difference of the longitudinal mode 67a down from the maximum intensity of the laser beam is 3dB or more. When such two laser beams are incident on the polarization maintaining fiber 8, being oriented at 45 degrees to the primary axes, they are decomposed into components along the primary axes. However, since these components are prevented from interfering, the degree of polarization of the synthesized beam is not affected very much. Similarly, although the longitudinal mode 67b belonging to the oscillation spectrum 65 overlaps with the longitudinal mode 66b belonging to the oscillation spectrum 64, the degree of polarization of the synthesized beam is not affected. Note that, in order to further decrease the degree of polarization, the separation of the center wavelengths selected by the diffraction gratings of the stripes may be set such that the oscillation spectra 64, 65 do not intersect in the region where the intensity difference down from the maximum intensities of the laser beams is 10dB or less.

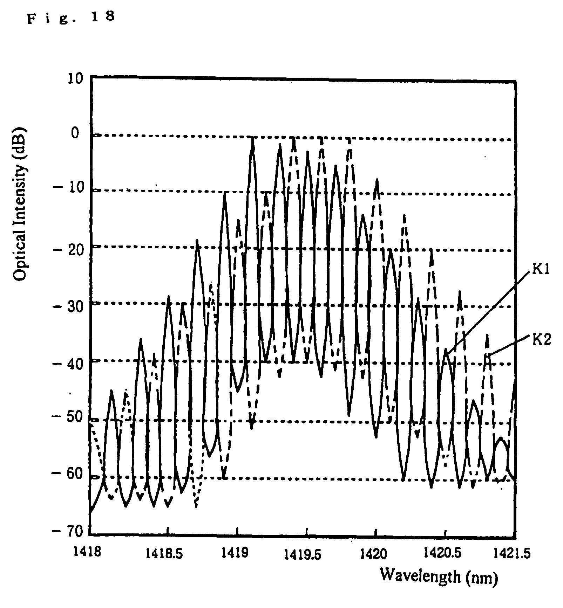

Further, another arrangement may be that, as shown in FIG. 18, the longitudinal modes of the laser beams K1, K2 emitted from the stripes are arranged such that each of the longitudinal modes belonging to the laser beam K1 differs in wavelengths from the longitudinal modes belonging to the laser beam K2, even when the spectrum of the laser beam K1 and that of the laser beam K2 intersect in their intense region. Preferably, the longitudinal modes of the laser beams K1, K2 may be arranged such that each of the longitudinal modes belonging to the laser beam K1 lies almost in the middle of two neighboring longitudinal modes belonging to the laser beam K2. When such two laser beams are incident on the polarization maintaining fiber 8, being oriented at 45 degrees to the primary axes, they are decomposed into components along the primary axes. However, since these components are prevented from interfering, the degree of polarization of the synthesized beam is not affected very much. Note that such an alternating arrangement of the longitudinal modes can be realized, for example, by varying the stripe width L1 of the first stripe from the stripe width L2 of the second stripe, which makes the heat dissipation from the light-emitting stripes different and results in the difference in temperature of the active layers between the stripes. The above-described another arrangement is not only applicable to the semiconductor laser device with a diffraction grating in each stripe, as shown in FIG. 14, but also to the semiconductor laser device without a diffraction grating, as shown in FIG. 8.

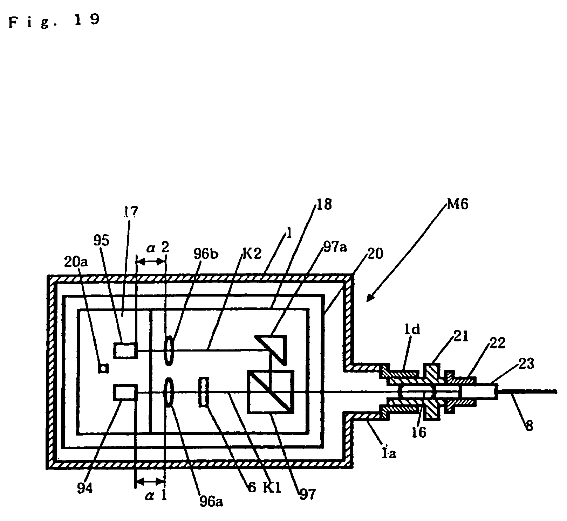

FIG. 19 is a plan view showing a semiconductor laser module in accordance with a second example useful for the understanding of the present invention. As shown in FIG. 19, the semiconductor laser module M6 in accordance with the second example useful for the understanding of the present invention includes: a first semiconductor laser device 94 emitting a first laser beam K1; a second semiconductor laser device 95 emitting a second laser beam K2; two first lenses 96a, 96b each collimating each of the two laser beams K1, K2 emitted from the two semiconductor laser devices 94, 95; a polarization synthesizer (a cube beam splitter) 97; and a reflective mirror 97a for reflecting the laser beam K2 toward the polarization synthesizer 97. The other constitutions of the semiconductor laser module are similar to those of the first example useful for the understanding.

In the second example, similarly to the first example, the polarization maintaining fiber 8 is fixed, being aligned such that the primary axes thereof are oriented at 45 degrees to each of the polarization directions of the two laser beams K1, K2. Hence, the synthesized beam is depolarized during propagation through the polarization maintaining fiber 8, and consequently, a sufficiently depolarized laser beam is obtained from an exit end of the polarization maintaining fiber 8 even in the presence of factors such as the imbalance in the intensities of the laser beams K1, K2 coupled to the polarization maintaining fiber 8 that would hinder the degree of polarization of the synthesized beam from being sufficiently small at the input end of the polarization maintaining fiber 8.

Note that, similarly to the first example, the wavelengths of the laser beams or the wavelengths of the longitudinal modes emitted from the stripes of the semiconductor laser devices may be shifted so that the degree of polarization is surely decreased.

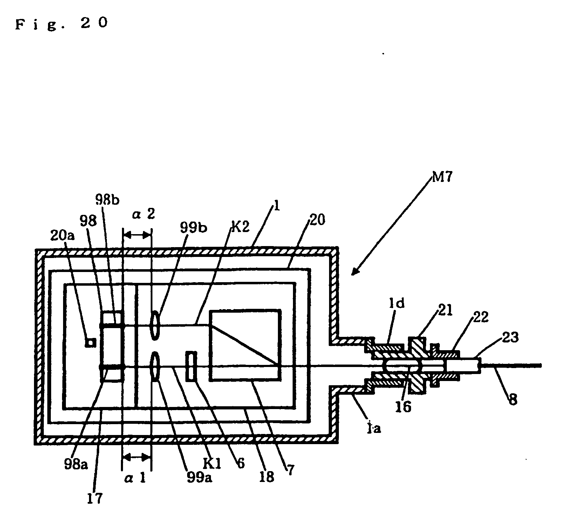

FIG. 20 is a plan view showing a semiconductor laser module in accordance with a third example useful for the understanding of the present invention.

The semiconductor laser module M7 in accordance with the third example includes: a semiconductor laser device 98 which is an array laser having a first stripe 98a and a second stripe 98b formed in parallel to each other with a spacing of about $500\mu$m interposed therebetween; a first lens 99a for collimating a first laser beam K1 emitted from the first stripe 98a; and a second lens 99b for collimating a second laser beam K2 emitted from the second stripe 98b. The other constitutions of the semiconductor laser module are similar to those of the first example.

In the third example of the present invention, similarly to the first example, the polarization maintaining fiber 8 is fixed, being aligned such that the primary axes thereof are oriented at 45 degrees to each of the polarization directions of the two laser beams K1, K2. Hence, the synthesized beam is depolarized during propagation through the polarization maintaining fiber 8, and consequently, a sufficiently depolarized laser beam is obtained from an exit end of the polarization maintaining fiber 8 even in the presence of factors such as the imbalance in the intensities of the laser beams K1, K2 coupled to the polarization maintaining fiber 8 that would hinder the degree of polarization of the synthesized beam from being sufficiently small at the input end of the polarization maintaining fiber 8.

In the third example also, similarly to the first example, the wavelengths of the laser beams or the wavelengths of the longitudinal modes emitted from the stripes may be shifted so that the degree of polarization is surely decreased.

In the third example, the semiconductor laser device 98 is an array laser having two stripes (with a spacing between the stripes being about $500\mu$m). However, it may be replaced by two discrete semiconductor laser devices arranged in parallel to each other with a small spacing interposed therebetween. In addition, the first lens may be replaced by a lens array.

In the second and third examples, the synthesized beam is sufficiently depolarized during propagation through the polarization maintaining fiber 8 even in the presence of factors such as the warpage of package occurred perpendicularly to the axial direction of the polarization maintaining fiber 8, which might cause difference in the coupling efficiency of each of the two laser beams to the polarization maintaining fiber 8 and consequent increase in the degree of polarization of the synthesized beam. Thus, the degree of polarization is stable over the variation in environmental temperature.

In addition, in the semiconductor laser modules M6 and M7 in accordance with the second and third examples, it is not necessary to fine adjust the injection current to the laser devices (or the stripes) for the purpose of decreasing the degree of polarization. That is, in the second example (FIG. 19) in which two laser devices are utilized and in the third example (FIG. 20) in which an array laser with a separated stripes is utilized, the amounts of current fed to the stripes are sometimes set different from each other in order to compensate for the difference in characteristics between the stripes. However, according to the present invention, since the polarization maintaining fiber 8 is fixed in the state that the primary axes thereof are oriented at 45 degrees to each of the polarization directions of the laser beams, a synthesized beam of decreased degree of polarization can be available from an output end of the polarization maintaining fiber 8 despite any small change in the current, if any, that would cause variation in intensities of the two laser beams.

(Sixth embodiment)

In an second embodiment, the semiconductor laser module according to the first through fifth embodiment is applied to a Raman amplifier.

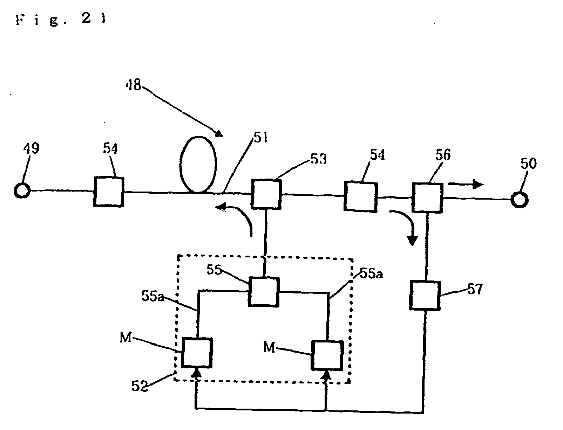

FIG. 21 is a block diagram showing a configuration of a Raman amplifier in accordance with the second embodiment of the present invention. The Raman amplifier is used in a WDM transmission communication system, for instance.

As shown in FIG. 21, the Raman amplifier 48 according to the second embodiment of the present invention comprises an input portion 49 to which a signal light is inputted, an output portion 50 from which the signal light is outputted, an optical fiber (an amplification fiber) 51 for transmitting the signal light between the input portion 49 and the output portion 50, a pumping light generating unit 52 for generating a pumping light, and a WDM coupler 53 for coupling the pumping light generated by the pumping light generating unit 52 and the signal light transmitted in the optical fiber (the amplification fiber) 51. Optical isolators 54 are disposed between the input portion 49 and the WDM coupler 53, and between the output portion 50 and the WDM coupler 53 as well, each allowing the signal light to be transmitted only in the direction from the input portion 49 to the output portion 50.

The pumping light generating unit 52 comprises a plurality of the semiconductor laser modules M according to any embodiment of the present invention each generating a laser light of a different wavelength from the others, and a WDM coupler 55 for synthesizing the laser lights generated from the plurality of semiconductor laser modules M.

The pumping lights generated by the semiconductor laser modules M, being transmitted through the polarization maintaining fibers 55a and synthesized by the WDM coupler 55, constitute the output light of the pumping light generating unit 52.

The pumping light outputted from the pumping light generating unit 52 is coupled with the optical fiber 51 through the WDM coupler 53, when the signal light inputted to the input portion 49 is mixed with the pumping light in the optical fiber 51. The signal light is then amplified, transmitted through the WDM coupler 53, and outputted from the output portion 50.

The signal light amplified in the optical fiber 51 (the amplified signal light) is transmitted through the WDM coupler 53 and the optical isolator 54, and then enters a monitor light distribution coupler 56, where a part of the amplified signal light is distributed to a control circuit 57 and the remaining part of it is outputted from the output portion 50 as the output signal light.

The control circuit 57 controls the laser emission state, such as the intensity, of optical output of each of the semiconductor laser modules M, on the basis of the part of the inputted amplified optical signal, and performs a feedback control of the semiconductor laser modules M such that a resultant optical amplification gain is flat over the wavelength.

The Raman amplifier 48, since it utilizes the semiconductor laser module in which the output beams from the stripes are polarization-synthesized and further depolarized through the polarization maintaining fiber 8, is capable of obtaining an amplification gain which is not only high but also stable irrespective of the state of polarization of the signal light.

In addition, if it utilizes the semiconductor laser module as explained in the first embodiment in which the semiconductor laser device further includes a diffraction grating 75 formed within each stripe to oscillate in a plurality of longitudinal modes, it is possible to reduce the noises added onto the amplified signal due to a reduced relative intensity noise (RIN) of the pumping light as compared with the case where the semiconductor laser module with a FBG is used. Still further, it is possible to suppress the occurrence of stimulated Brillouin scattering of the pumping light, whereby the amplification can be performed with low extra noises and high gain.

In FIG. 21, the Raman amplifier is realized as a backward pumped amplifier. However, it should be noted that since the Raman amplifier utilizes the semiconductor laser module emitting a depolarized pumping light of low relative intensity noise (RIN), it is possible to obtain a stable gain irrespective of the state of polarization of the signal light, even if it is realized as any of a forward pumped amplifier or a bi-directional pumped amplifier.

Obviously, the present invention is not limited to the embodiments described above, and additional numerous modifications and variations of the present invention are possible within the scope of the appended claims.

According to the present invention, the optical fiber is a polarization maintaining fiber, and is aligned such that the mutually orthogonal two primary axes thereof are oriented at approximately 45 degrees to each of the polarization directions of the two laser beams, allowing the polarization maintaining fiber to function as a depolarizer. Thus, a sufficiently depolarized laser beam can be available from an output end of the optical fiber despite a possible imbalance of the intensities of the laser beams coupled to the polarization maintaining fiber 8 that would hinder the degree of polarization (DOP) from being sufficiently small. In addition, the present invention can provide a semiconductor laser module in which the degree of polarization of the synthesized beam outputted from the optical fiber is stable over the change in ambient temperature or the like. Therefore, the semiconductor laser modules of the present embodiments can be preferably used as pumping light sources of Raman amplifiers which generally require a low polarization dependency of amplification gain.

Further, in the present invention, since the depolarization is achieved to some extent at the position of coupling of the laser beams to the optical fiber, the length of the polarization maintaining fiber necessary for depolarization can be short. Thus, it is possible to downsize equipments and to reduce their cost. In summary, the present invention relates to a semiconductor laser module comprising a semiconductor laser device having a stripe emitting a laser beam, a polarization synthesizer configured to polarization synthesize a first laser beam and a second laser beam emitted from said stripe of said semiconductor laser device, a package accommodating said semiconductor laser device, and an optical fiber for receiving the synthesized laser beam emerging from said polarization synthesizer, wherein said optical fiber is a polarization maintaining fiber, and wherein said optical fiber is fixed to said package in a state that two mutually orthogonal primary axes thereof are oriented at approximately 45 degrees to each of the polarization directions of said first laser beam and second laser beam. Each stripe of said semiconductor laser device includes a diffraction grating. The oscillation spectrum of said first laser beam and the oscillation spectrum of said second laser beam do not intersect in the range where the intensity difference from the maximum is 3dB or less.

In a preferred embodiment, said semiconductor laser device is a single semiconductor laser device comprising a first stripe and a second stripe formed with a spacing interposed therebetween, and emitting respectively said first laser beam and said second laser beam from one end face thereof. It is further preferred that said first stripe and said second stripe are arranged with the spacing of 100 μm or less.

The present invention also relates to a Raman amplifier comprising one of the above mentioned semiconductor laser modules as a pumping light source.

## Claims

1. A semiconductor laser module (M1; M2; M3; M4; M5; M6; M7; M) comprising:

    a first stripe (9; 98a) emitting a first laser beam (K1) and a second stripe (10;98b) emitting a second laser beam (K2), the first stripe and the second stripe each including a diffraction grating (75);
    a polarization synthesizer (59; 97) configured to polarization synthesize the first laser beam and the second laser beam emitted from said first stripe and said second stripe;
    a package (1) accommodating said semiconductor laser device; and
    an optical fiber (8) configured to receive the synthesized laser beam emerging from said polarization synthesizer,

    wherein said optical fiber (8) is a polarization maintaining fiber,
    wherein said optical fiber (8) is fixed to said package (1) in a state that two mutually orthogonal primary axes thereof are oriented at approximately 45 degrees to each of the polarization directions of said first laser beam and said second laser beam, and
    wherein the diffraction gratings (75) formed in each of the stripes are configured so that the oscillation spectrum of said first laser beam (K1) and the oscillation spectrum of said second laser beam (K2) do not intersect in the range where the intensity difference from the maximum is 3dB or less.

2. The semiconductor laser module according to claim 1, wherein said first stripe and said second stripe are arrayed on a single semiconductor substrate (24; 69) with a spacing interposed there between to form a single semiconductor laser device.

3. The semiconductor laser module according to claim 2, wherein said first stripe and said second stripe are arranged with the spacing of 100 $\mu$m or less.

4. A Raman amplifier (48) comprising a semiconductor laser module (M1; M2; M3; M4; M5; M6; M7; M) according to any one of claim 1 to 3 as a pumping light source.

**Patentansprüche**

1. Halbleiterlasermodul (M1; M2; M3; M4; M5; M6; M7; M) umfassend:

einen ersten Streifen (9; 98a), der einen ersten Laserstrahl (K1) emittiert, und einen zweiten Streifen (10; 98b), der einen zweiten Laserstrahl (K2) emittiert, wobei der erste Streifen und der zweite Streifen jeweils ein Beugungsgitter (75) beinhalten;
einen Polarisationssynthesizer (59; 97), der ausgebildet ist, um den ersten Laserstrahl und den zweiten Laserstrahl, die von dem ersten Streifen und dem zweiten Streifen emittiert werden, zu polarisationssynthetisieren;
ein Gehäuse (1), das das Halbleiterlasergerät aufnimmt; und
einen Lichtleiter (8), der ausgebildet ist, um den synthetisierten Laserstrahl, der aus dem Polarisationssynthesizer hervorgeht, aufzunehmen,

wobei der Lichtleiter (8) ein polarisationserhaltender Lichtleiter ist,
wobei der Lichtleiter (8) an dem Gehäuse (1) in einem Zustand befestigt ist, so daß zwei zueinander orthogonale Hauptachsen davon ungefähr mit 45° zu einer jeweiligen Polarisationsrichtung des ersten Laserstrahls und des zweiten Laserstrahls ausgerichtet sind, und
wobei die in einem jeweiligen der Streifen ausgebildeten Beugungsgitter (75) so ausgebildet sind, daß das Schwingungsspektrum des ersten Laserstrahls (K1) und das Schwingungsspektrum des zweiten Laserstrahls (K2) sich nicht dem Bereich überlappen, in dem der Intensitätsunterschied bezüglich des Maximums 3 dB oder weniger ist.

2. Halbleiterlasermodul nach Anspruch 1, wobei der erste Streifen und der zweite Streifen auf einem einzigen Halbleitersubstrat (24; 69) mit einem Abstand zwischen sich angeordnet sind, um ein einzelnes Halbleiterlasergerät zu bilden.

3. Halbleiterlasermodul nach Anspruch 2, wobei der erste Streifen und der zweite Streifen mit einem Abstand von 100 $\mu$m oder weniger angeordnet sind.

4. Ramanverstärker (48), umfassend ein Halbleiterlasermodul (M1; M2; M3; M4; M5; M6; M7; M) gemäß einem der Ansprüche 1 bis 3 als Pumplichtquelle.

**Revendications**

1. Module de laser à semi-conducteur (M1;M2;M3;M4;M5; M6;M7;M) comprenant :

une première bande (9 ; 98a) émettant un premier faisceau laser (K1) et une seconde bande (10 ; 98b) émettant un second faisceau laser (K2), la première bande et la seconde bande incluant chacune un réseau de diffraction (75) ;
un synthétiseur de polarisation (59; 97) configuré pour synthétiser, avec polarisation, le premier faisceau laser et le second faisceau laser émis depuis ladite première bande et ladite seconde bande ;
un boîtier (1) recevant ledit module de laser à semi-conducteur ; et
une fibre optique (8) configurée pour recevoir le faisceau laser synthétisé émergeant dudit synthétiseur de polarisation ;

où ladite fibre optique (8) est une fibre maintenant la polarisation ;
où ladite fibre optique (8) est fixée audit boîtier (1) en un état tel que deux axes principaux mutuellement orthogonaux de celle-ci sont orientés approximativement à 45 degrés par rapport à chacune des directions de polarisation dudit premier faisceau laser et dudit second faisceau laser, et
où les réseaux de diffraction (75) formés dans chacune des bandes sont configurés de sorte que le spectre d'oscillation dudit premier faisceau laser (K1) et le spectre d'oscillation dudit second faisceau laser (K2) ne sont pas sécants dans la gamme où la différence d'intensité à compter du maximum est de 3 dB ou moins.

2. Module de laser à semi-conducteur selon la revendication 1, dans lequel ladite première bande et ladite seconde bande sont agencées sur un substrat de semi-conducteur unique (24 ; 69) avec, entre elles, un espacement pour former un dispositif laser à unique semi-conducteur.

3. Module de laser à semi-conducteur selon la revendication 2, dans lequel ladite première bande et ladite seconde bande sont agencées avec un espacement de 100 $\mu$m ou moins.

4. Amplificateur Raman comprenant un module de laser à semi-conducteur (M1;M2;M3;M4;M5;M6;M7;M) selon l'une quelconque des revendications 1 à 3 comme source lumineuse de pompage.

M1

1c

59

12 20a 13 5 6 7 1b 1d 16 21 22 23

3 2

4

19b

19a

14

18

20

1a

8

11 17 17a

1

Y

X

Z

F i g. 1 (A)

2

58

11

F i g. 1 (B)

Fig. 2(A)

Fig. 2(B)

The polarization direction of the laser beam K1

The polarization direction of the laser beam K2

45 degrees

C : core

P : stress applying part

S : slow axis

F : fast axis

Fig. 3(A)

Fig. 3(B)

Fig. 4(A)

Fig. 4(B)

YAG laser-welding spot

Fig. 4(C)

Fig. 4(D)

Fig. 5

Fig. 6

F i g. 7(A)

F i g. 7(B)

Fig. 8(A)

Fig. 8(B)

Fig. 9

Fig. 10

Fig. 11

EP 1 411 601 B1

M4

2  9  K1  A  6  7b  7  16  23

K2  10  7a  8

X

Y

Z

**F i g . 1 2**

Fig. 13

F i g . 1 4(A)

F i g . 1 4 (B)

F i g . 1 4 (C)

Fig. 15

Fig. 16 (B)

Fig. 16 (A)

Fig. 17

Fig. 18

Fig. 19

Fig. 20

Fig. 21

Fig. 22